(19)

Europäisches Patentamt
European Patent Office
Office européen des brevets

(11) **EP 4 764 534 A1**

(12) **EUROPEAN PATENT APPLICATION**
published in accordance with Art. 153(4) EPC

(43) Date of publication:
**24.06.2026 Bulletin 2026/26**

(21) Application number: **25736320.0**

(22) Date of filing: **06.01.2025**

(51) International Patent Classification (IPC):
*G01R 31/3835* (2019.01)    *G01R 31/396* (2019.01)
*G01R 19/10* (2006.01)    *G01R 19/165* (2006.01)
*G01R 19/30* (2006.01)

(52) Cooperative Patent Classification (CPC):
**G01R 19/10; G01R 19/165; G01R 19/30;
G01R 31/3835; G01R 31/396**

(86) International application number:
**PCT/KR2025/000199**

(87) International publication number:
**WO 2025/147166 (10.07.2025 Gazette 2025/28)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **05.01.2024 KR 20240002060**

(71) Applicant: **LG Energy Solution, Ltd.
Seoul 07335 (KR)**

(72) Inventor: **ROH, Jung Hyeon
Daejeon 34122 (KR)**

(74) Representative: **Plasseraud IP
104 Rue de Richelieu
CS92104
75080 Paris Cedex 02 (FR)**

(54) **BATTERY DIAGNOSIS DEVICE AND OPERATING METHOD THEREOF**

(57)    A battery diagnosis device according to one embodiment disclosed in this document may include an acquisition unit that acquires open circuit voltage (OCV) data of a plurality of battery cells, a calculation unit that calculates, for each of the plurality of battery cells, an OCV difference value between a first OCV value corresponding to a first charge/discharge cycle and a second OCV value corresponding to a second charge/-discharge cycle after the first charge/discharge cycle based on the OCV data, a normalization unit that acquires normalized OCV difference values by normalizing OCV difference values of the plurality of battery cells, an identification unit that identifies a suspected abnormal battery cell among the plurality of battery cells based on the normalized OCV difference values, and a diagnosis unit that diagnoses an abnormality of the suspected abnormal battery cell based on an OCV deviation value between a second OCV value of the identified suspected abnormal battery cell and a representative value of second OCV values of the plurality of battery cells.

FIG.1

**Description**

## CROSS-REFERENCE TO RELATED APPLICATION

The present application claims the benefit of the priority of Korean Patent Application No. 10-2024-0002060, filed on January 5, 2024, which is hereby incorporated by reference in its entirety.

## TECHNICAL FIELD

Embodiments disclosed in this document relate to a battery diagnosis device and an operating method thereof.

## BACKGROUND ART

Recently, research and development on secondary batteries have been actively conducted. Here, secondary batteries are batteries that can be charged and discharged, and include both conventional Ni/Cd batteries, Ni/MH batteries, and recent lithium ion batteries. Among secondary batteries, lithium ion batteries have the advantage of having much higher energy density than conventional Ni/Cd batteries, Ni/MH batteries, etc. In addition, lithium ion batteries may be manufactured to be small and lightweight, and thus the lithium ion batteries are used as a power source for mobile devices. Recently, the scope of use of the lithium ion batteries has expanded to include a power source for electric vehicles, and the lithium ion batteries are attracting attention as a next-generation energy storage medium.

In addition, the secondary batteries may generally be used as a battery pack that includes battery modules in each of which a plurality of battery cells are connected in series and/or in parallel. In addition, the secondary batteries may be used as a battery rack that include a plurality of battery modules and a rack frame that accommodate these battery modules.

Such battery cells, battery modules, battery packs, or battery racks may be utilized in various devices. For example, batteries may be utilized in mobile devices such as mobile phones, laptop computers, smart phones, and smart pads, but also in the field of electric vehicles (EVs, HEVs, PHEVs) and large-capacity power storage devices (ESS).

The state and operation of these batteries may be managed and controlled by a battery management system (BMS). The battery management system may be included together with a battery within one device.

In addition, the battery management system may manage and control the battery while being separated from a device including the battery. For example, the battery management system may be implemented as a separate server device. In this case, the battery management system may collect battery data and vehicle data from vehicles, etc., and manage and control the battery using the collected data.

## DISCLOSURE OF THE INVENTION

## TECHNICAL PROBLEM

On the other hand, when there is a defect in a battery, the possibility of damage to devices including (e.g., EV, ESS) the battery may increase. Accordingly, a method for detecting an abnormal state of the battery and reducing the possibility of damage to devices including the battery is required.

The embodiments disclosed in this document may provide a battery diagnosis device that can diagnose an abnormality of a battery using a charge/discharge cycle open circuit voltage (OCV) difference value and an operating method thereof.

The technical problems of the embodiments disclosed in this document are not limited to the technical problems mentioned above, and other technical problems that are not mentioned may be clearly understood by those skilled in the art from the descriptions below.

## TECHNICAL SOLUTION

A battery diagnosis device according to one embodiment disclosed in this document may include an acquisition unit that acquires open circuit voltage (OCV) data of a plurality of battery cells, a calculation unit that calculates, for each of the plurality of battery cells, an OCV difference value between a first OCV value corresponding to a first charge/discharge cycle and a second OCV value corresponding to a second charge/discharge cycle after the first charge/discharge cycle based on the OCV data, a normalization unit that acquires normalized OCV difference values by normalizing OCV difference values of the plurality of battery cells, an identification unit that identifies a suspected abnormal battery cell among the plurality of battery cells based on the normalized OCV difference values, and a diagnosis unit that diagnoses an abnormality of the suspected abnormal battery cell based on an OCV deviation value between a second OCV value of the identified suspected abnormal battery cell and a representative value of second OCV values of the plurality of battery cells.

In the battery diagnosis device according to one embodiment disclosed in this document, the normalization unit may normalize the OCV difference values of the plurality of battery cells based on Equation 1 below to acquire the normalized OCV difference values.

$$[\text{Equation 1}]$$

$$\frac{dOCV_i - dOCV_{\min}}{dOCV_{\max} - dOCV_{\min}}$$

(In Equation 1, $dOCV_i$ is the OCV difference value of an i-th battery cell among the plurality of battery cells, $dOCV_{\min}$ is a minimum value of the OCV difference values of the plurality of battery cells, and $dOCV_{max}$ is a maximum value of the OCV difference values of the plurality of battery cells.)

In the battery diagnosis device according to one embodiment disclosed in this document, the identification unit may identify the suspected abnormal battery cell among the plurality of battery cells based on a deviation between the normalized OCV difference values.

In the battery diagnosis device according to one embodiment disclosed in this document, when a deviation between a maximum value and a second largest value among the normalized OCV difference values is greater than or equal to a first threshold value, the identification unit may identify a battery cell having the maximum value as the suspected abnormal battery cell.

In the battery diagnosis device according to one embodiment disclosed in this document, when a deviation between a minimum value and a second smallest value among the normalized OCV difference values is greater than or equal to a second threshold value, the identification unit may identify a battery cell having the minimum value as the suspected abnormal battery cell.

In the battery diagnosis device according to one embodiment disclosed in this document, when the OCV deviation value of the suspected abnormal battery cell is greater than or equal to a third threshold value, the diagnosis unit may diagnose the suspected abnormal battery cell as an abnormal battery cell.

In the battery diagnosis device according to one embodiment disclosed in this document, the first OCV value may be an OCV value corresponding to a charge cycle included in the first charge/discharge cycle, and the second OCV value may be an OCV value corresponding to a charge cycle included in the second charge/-discharge cycle.

In the battery diagnosis device according to one embodiment disclosed in this document, the first OCV value may be an OCV value corresponding to a discharge cycle included in the first charge/discharge cycle, and the second OCV value may be an OCV value corresponding to a discharge cycle included in the second charge/-discharge cycle.

An operating method of a battery diagnosis device according to one embodiment disclosed in this document may include an operation of acquiring open circuit voltage (OCV) data of a plurality of battery cells, an operation of calculating, for each of the plurality of battery cells, an OCV difference value between a first OCV value corresponding to a first charge/discharge cycle and a second OCV value corresponding to a second charge/-discharge cycle after the first charge/discharge cycle based on the OCV data, an operation of acquiring normalized OCV difference values by normalizing the OCV difference values of the plurality of battery cells, an operation of identifying a suspected abnormal battery cell among the plurality of battery cells based on the normalized OCV difference values, and an operation of diagnosing an abnormality of the suspected abnormal battery cell based on an OCV deviation value between a second OCV value of the identified suspected abnormal battery cell and a representative value of second OCV values of the plurality of battery cells.

In the operating method of the battery diagnosis device according to one embodiment disclosed in this document, the operation of acquiring the normalized OCV difference values may include an operation of acquiring the normalized OCV difference values by normalizing the OCV difference values of the plurality of battery cells based on Equation 1 above.

In the operating method of the battery diagnosis device according to one embodiment disclosed in this document, the operation of identifying the suspected abnormal battery cell may include an operation of identifying the suspected abnormal battery cell among the plurality of battery cells based on a deviation between the normalized OCV difference values.

In the operating method of the battery diagnosis device according to one embodiment disclosed in this document, the operation of identifying the suspected abnormal battery cell may include an operation of identifying, when a deviation between the maximum value and the second largest value among the normalized OCV difference values is greater than or equal to a first threshold value, a battery cell having the maximum value as the suspected abnormal battery cell.

In the operating method of the battery diagnosis device according to one embodiment disclosed in this document, the operation of identifying the suspected abnormal battery cell may include an operation of identifying, when a deviation between the minimum value and the second smallest value among the normalized OCV difference values is greater than or equal to a second threshold value, a battery cell having the minimum value as the suspected abnormal battery cell.

In the operating method of the battery diagnosis device according to one embodiment disclosed in this document, the operation of diagnosing the abnormality of the suspected abnormal battery cell may include an operation of diagnosing the suspected abnormal battery cell as an abnormal battery cell when the OCV deviation value of the suspected abnormal battery cell is greater than or equal to a third threshold value.

In the operating method of the battery diagnosis device according to one embodiment disclosed in this document, the first OCV value may be an OCV value corresponding to a charge cycle included in the first charge/discharge cycle, and the second OCV value may be an OCV value corresponding to a charge cycle included in the second charge/discharge cycle.

## ADVANTAGEOUS EFFECTS

According to the embodiments disclosed in this document, micro-abnormal behavior of the battery voltage can be accurately diagnosed through normalization of the OCV difference value.

In addition, various effects that can be directly or indirectly identified through this document can be provided.

## BRIEF DESCRIPTION OF THE DRAWINGS

FIG. 1 is a block diagram of a battery diagnosis device according to one embodiment.

FIGS. 2A and 2B are graphs illustrating OCV difference values calculated for each of a plurality of battery cells by a battery diagnosis device according to one embodiment.

FIG. 3 is a graph illustrating normalized OCV difference values acquired by normalizing OCV difference values by a battery diagnosis device according to one embodiment.

FIG. 4 is a flowchart illustrating an operation of a battery diagnosis device according to one embodiment.

## MODE FOR CARRYING OUT THE INVENTION

Hereinafter, embodiments described in this document are described with reference to the accompanying drawings. However, this is not intended to limit the disclosure of this document to a specific embodiment, but should be understood to include various modifications, equivalents, and/or alternatives of the embodiments described in this document.

Various embodiments of this document and the terms used therein are not intended to limit the technical features described in this document to a specific embodiment, but should be understood to include various modifications, equivalents, or alternatives of the embodiment. In connection with the description of the drawings, similar reference numerals may be used for similar or related components. The singular form of a noun corresponding to an item may include one or more of said items, unless the context clearly indicates otherwise.

In this document, each of phrases "A or B", "at least one of A and B", "at least one of A or B", "A, B, or C", "at least one of A, B, and C", and "at least one of A, B, or C" may include any one of the items listed together in that phrase, or all possible combinations thereof. Terms such as "first", "second", "firstly", "secondly", "A", "B", "(a)", or "(b)" may be used merely to distinguish one component from another, and do not limit the components in any other respect (e.g., importance or order) unless specifically stated otherwise.

In this document, when a component (e.g., a first component) is referred to as being "connected", "coupled" or "joined" to another component (e.g., a second component), with or without the terms "functionally" or "communicatively", it means that the component can be connected to the other component directly (e.g., in a wired manner), wirelessly, or through a third component.

According to various embodiments, each of the components (e.g., modules or programs) described above may include a single or plurality of entities, and some of the plurality of entities may be separated and placed in other components. According to various embodiments, one or more of the components or operations described above may be omitted, or one or more other components or operations may be added. Alternatively or additionally, a plurality of components (e.g., modules or programs) may be integrated into a single component. In such a case, the integrated component may perform one or more functions of each of the plurality of components identically or similarly to those performed by the corresponding component among the plurality of components prior to the integration. According to various embodiments, the operations performed by a module, program, or other component may be performed sequentially, in parallel, repeatedly, or heuristically, or one or more of the operations may be performed in a different order, omitted, or performed by being added with one or more other operations.

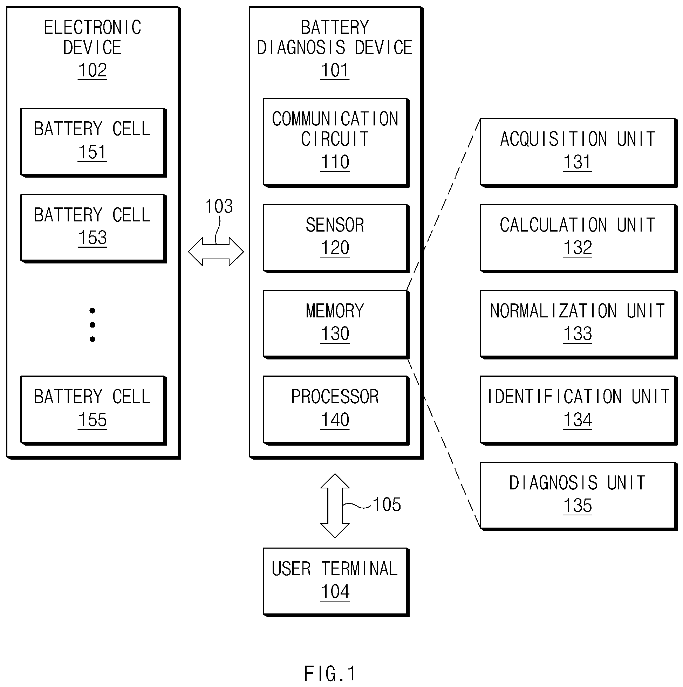

FIG. 1 is a block diagram of a battery diagnosis device according to one embodiment.

A battery diagnosis device 101 which will be described below may be implemented as a battery management system (BMS) within an electronic device 102, and may also be implemented as various external devices such as a server, a cloud, a charger, or a charger/discharger.

Referring to FIG. 1, the battery diagnosis device 101 may be connected to the electronic device 102 and a user terminal 104 in a wired manner and/or wirelessly.

According to one embodiment, a connection 103 between the battery diagnosis device 101 and the electronic device 102 may be a communication connection via a wired and/or wireless network. In one embodiment, the wired network may be based on local area network (LAN) communication or power line communication. In one embodiment, the wireless network may be based on a short-range communication network (e.g., Bluetooth, wireless fidelity (WiFi) or infrared data association (IrDA)), or a long-range communication network (a cellular network, 4G network, 5G network).

According to another embodiment, the connection 103 between the battery diagnosis device 101 and the electronic device 102 may be a connection via an inter-device communication method (e.g., a bus, a general purpose input and output (GPIO), a serial peripheral interface (SPI), or a mobile industry processor interface (MIPI)).

According to one embodiment, the electronic device 102 may be a mobile device (e.g., a mobile phone, a laptop computer, a smart phone, a smart pad), an electric vehicle (e.g., an electric vehicle (EV), a hybrid EV (HEV), a plug-in HEV (PHEV), a fuel cell EV (FCEV)), an energy storage system (ESS), or a battery swapping system (BSS).

According to one embodiment, the electronic device 102 may include a plurality of battery cells 151, 153, and 155. According to one embodiment, the plurality of battery cells 151, 153, and 155 may be included in one battery module or one battery pack.

According to one embodiment, a connection 105 between the battery diagnosis device 101 and the user terminal 104 may be a communication connection via a wired and/or wireless network.

According to one embodiment, the user terminal 104 may be a mobile device (e.g., a mobile phone, a laptop computer, a smart phone, and a smart pad), or a personal computer (PC). According to one embodiment, the battery diagnosis device 101 may provide information related to the diagnosis result of the battery unit 151, 153, or 155 to the user terminal 104.

According to one embodiment, the battery diagnosis device 101 may include a communication circuit 110, a sensor 120, a memory 130, and a processor 140. According to one embodiment, the battery diagnosis device 101 illustrated in FIG. 1 may further include at least one component (e.g., a display, an input device, or an output device) other than the components illustrated in FIG. 1, or at least one component (e.g., the sensor 120) among the components illustrated in FIG. 1 may be omitted. For example, when the battery diagnosis device 101 is implemented as an external electronic device separate from the electronic device 102, such as a server or cloud, the battery diagnosis device 101 may acquire state information of the plurality of battery cells 151, 153, and 155 using the communication circuit 110. In this case, the sensor 120 may not be included in the battery diagnosis device 101.

According to one embodiment, the communication circuit 110 may establish a wired communication channel and/or a wireless communication channel between the battery diagnosis device 101 and the electronic device 102 and/or the user terminal 104, and may transmit and receive data to and from the electronic device 102 and/or the user terminal 104 through the established communication channel.

According to one embodiment, the sensor 120 may measure information (e.g., voltage, current, temperature, etc.) related to a state of the plurality of battery cells 151, 153, and 155 of the electronic device 102. For example, when the battery diagnosis device 101 is implemented as the BMS within the electronic device, the battery diagnosis device 101 may directly measure state values of the plurality of battery cells 151, 153, and 155 using the sensor 120.

According to one embodiment, the communication circuit 110 and/or the sensor 120 may acquire time series data related to the states of the plurality of battery cells 151, 153, and 155. In one embodiment, the time series data related to the states of the plurality of battery cells 151, 153, and 155 may be data representing voltage, current, resistance, state of charge (SOC), state of health (SOH), and/or temperature of the plurality of battery cells 151, 153, and 155 over time.

According to one embodiment, the memory 130 may include a volatile memory and/or a nonvolatile memory.

According to one embodiment, the memory 130 may store data used by at least one component (e.g., processor 140) of the battery diagnosis device 101. For example, data may include software (or instructions related thereto), input data, or output data. In one embodiment, the instructions, when executed by the processor 140, may cause the battery abnormality diagnosis device 101 to perform operations defined by the instructions.

According to one embodiment, the memory 130 may include one or more software (e.g., an acquisition unit 131, a calculation unit 132, a normalization unit 133, an identification unit 134, and a diagnosis unit 135).

According to one embodiment, the processor 140 may include a central processing unit, an application processor, a graphics processing unit, a neural processing unit (NPU), an image signal processor, a sensor hub processor, or a communication processor.

According to one embodiment, the processor 140 may execute software stored in the memory 130 (e.g., hardware or software components) to control at least one other component of the battery diagnosis device 101 (e.g., the acquisition unit 131, the calculation unit 132, the normalization unit 133, the identification unit 134, and the diagnosis unit 135) connected to the processor 140, and may perform various data processing or computations.

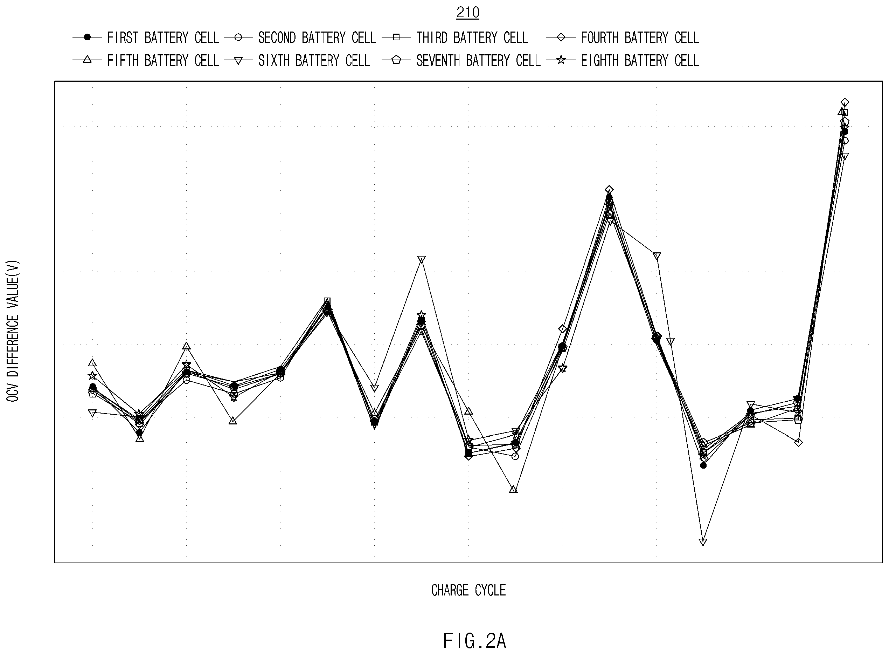

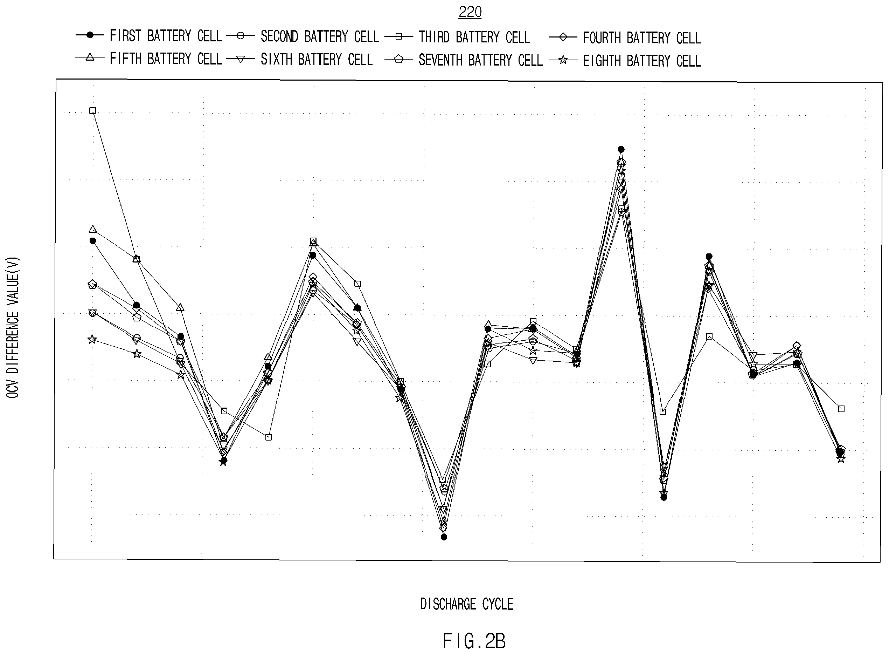

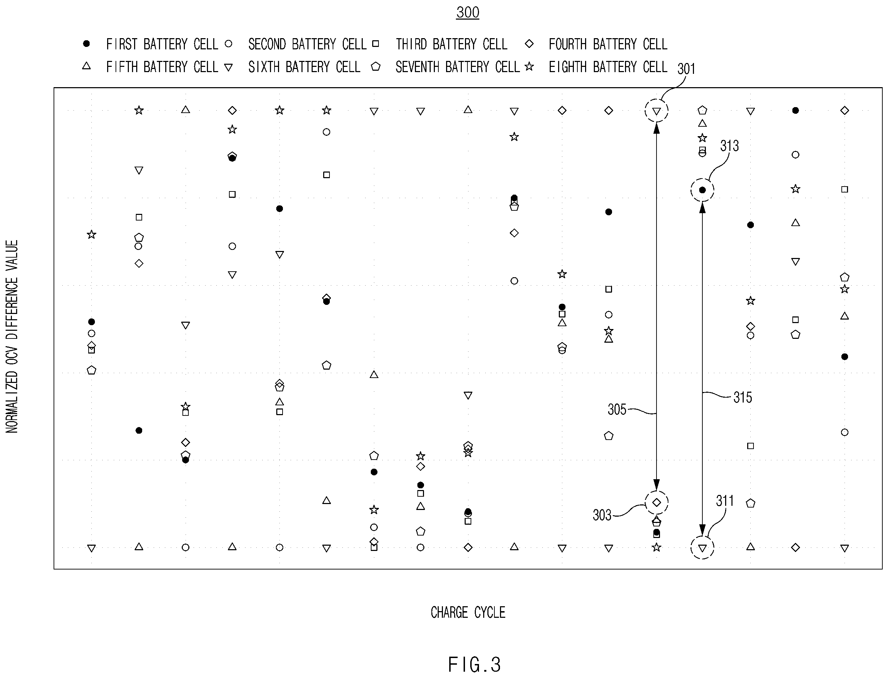

Hereinafter, a method in which the battery diagnosis device 101 diagnoses abnormalities of the plurality of battery cells 151, 153, and 155 through the acquisition unit 131, the calculation unit 132, the normalization unit 133, the identification unit 134, and the diagnosis unit 135 will be described with reference to FIGS. 2A, 2B, and 3.

FIGS. 2A and 2B are graphs illustrating OCV difference values calculated for each of a plurality of battery cells by a battery diagnosis device according to one embodiment. FIG. 3 is a graph illustrating normalized OCV difference values acquired by normalizing OCV difference values by the battery diagnosis device according to the embodiment.

According to one embodiment, the acquisition unit 131 may acquire open circuit voltage (OCV) data of the plurality of battery cells 151, 153, and 155. For example, the acquisition unit 131 may measure voltage, current, and/or temperature of the plurality of battery cells 151, 153, and 155 and generate OCV data based on the measured information. In this case, the acquisition unit 131 may use the sensor 120 to measure voltage, current, and/or temperature of the plurality of battery cells 151, 153, and 155. As another example, the acquisition unit 131 may receive OCV data of the plurality of battery cells 151, 153, and 155 generated by the electronic device 102 from the electronic device 102 using the communication circuit 110.

According to one embodiment, the calculation unit 132 may calculate an OCV difference value for each of the plurality of battery cells 151, 153, and 155 based on the OCV data. The OCV difference value may be a difference value between two OCV values corresponding to each of two charge/discharge cycles among a plurality of charge/discharge cycles included in a time period of the OCV data. Here, the charge/discharge cycle may include a charge cycle and a discharge cycle.

According to one embodiment, the OCV difference value may be a difference value between a first OCV value corresponding to a first charge/discharge cycle among the plurality of charge/discharge cycles and a second OCV value corresponding to a second charge/discharge cycle among the plurality of charge/discharge cycles. In this case, the second charge/discharge cycle may be a cycle adjacent to the first charge/discharge cycle after the first charge/discharge cycle. In addition, the OCV difference value may be a value acquired by subtracting the first OCV value from the second OCV value.

Hereinafter, the current charge/discharge cycle to be diagnosed may be referred to as a second charge/discharge cycle, and an immediately preceding charge/discharge cycle may be referred to as a first charge/discharge cycle. In addition, the OCV value of the battery cell 151, 153, and/or 155 corresponding to the first charge/discharge cycle may be referred to as the first OCV value, and the OCV value of the battery cell 151, 153, and/or 155 corresponding to the second charge/discharge cycle may be referred to as the second OCV value.

According to one embodiment, the calculation unit 132 may calculate the OCV difference value based on one type of the charge cycle or the discharge cycle included in the charge/discharge cycle.

For example, the calculation unit 132 may calculate the OCV difference value between the first OCV value corresponding to the first charge cycle among the plurality of charge cycles included in a time section of the OCV data and the second OCV value corresponding to the second charge cycle after the first charge cycle. In this case, the OCV value corresponding to each charge cycle may be selected as an OCV value at a time point after a designated time (e.g., 2 hours) has passed after each charge cycle ends. For example, the calculation unit 132 may calculate a difference value between the first OCV value at a time point after a designated time has passed after the end of the first charge cycle and the second OCV value at a time point after a designated time has passed after the end of the second charge cycle as the OCV difference value.

As another example, the calculation unit 132 may calculate an OCV difference value between the first OCV value corresponding to the first discharge cycle and the second OCV value corresponding to the second discharge cycle after the first discharge cycle among the plurality of discharge cycles included in the time section of the OCV data. In this case, the OCV value corresponding to each discharge cycle may be selected as an OCV value at a time point after a designated time (e.g., 2 hours) has passed after each discharge cycle ends. For example, the calculation unit 132 may calculate a difference value between the first OCV value at a time point after a designated time has passed after the end of the first discharge cycle and the second OCV value at a time point after a designated time has passed after the end of the second discharge cycle as the OCV difference value.

Referring to FIG. 2A and FIG. 2B, graphs 210 and 220 illustrating OCV difference values for the charge cycle or discharge cycle of battery cells to be diagnosed calculated by the calculation unit 132 may be confirmed.

In the graphs 210 and 220, the OCV difference values corresponding to a specific charge cycle or a specific discharge cycle correspond to each of the battery cells to be diagnosed, and may be a difference value between the OCV value corresponding to the specific cycle and the OCV value corresponding to the immediately preceding cycle. For example, in the graph 210, an OCV difference value corresponding to a third charge cycle of a first battery cell among the battery cells to be diagnosed may be a difference value between an OCV value corresponding to the third charge cycle of the first battery cell and an OCV value corresponding to a second charge cycle thereof.

According to one embodiment, the normalization unit 133 may acquire normalized OCV difference values by normalizing the OCV difference values of the plurality of battery cells 151, 153, and 155 calculated by the calculation unit 132. For example, the normalization unit 133 may acquire the normalized OCV difference values by normalizing the OCV difference values based on Equation 1 below.

$$[\text{Equation 1}]$$

$$\frac{dOCV_i - dOCV_{\min}}{dOCV_{\max} - dOCV_{\min}}$$

In Equation 1 above, $dOCV_i$ is an OCV difference value of an i-th battery cell (where i is a natural number) among the plurality of battery cells 151, 153, and 155, $dOCV_{\min}$ is the minimum value of OCV difference values of the plurality of battery cells 151, 153, and 155, and $dOCV_{\max}$ is the maximum value of the OCV difference values of the plurality of battery cells 151, 153, and 155.

Referring to FIG. 3, a graph 300 illustrating normalized OCV difference values for the charge cycles of the battery cells to be diagnosed acquired by the normalization unit 133 may be confirmed. Specifically, the graph 300 may illustrate normalized OCV difference values acquired by normalizing the OCV difference values of the battery cells to be diagnosed according to the graph 210 of FIG. 2A by the normalization unit 133.

In the graph 300, the normalized OCV difference values corresponding to a specific charge cycle correspond to each of the battery cells to be diagnosed, and may be values calculated by inputting the OCV difference values of the battery cells to be diagnosed corresponding to the specific charge cycle into the Equation 1 above. For example, in the graph 300, a normalized OCV difference value corresponding to a thirteenth charge cycle of the first battery cell among the battery cells to be diagnosed may be a value calculated by inputting the OCV difference value corresponding to the thirteenth charge cycle of the battery cells to be diagnosed and the minimum value and maximum value of the OCV difference values corresponding to the thirteenth charge cycle of the first battery cell into Equation 1 above.

According to one embodiment, the identification unit 134 may identify a suspected abnormal battery cell among the plurality of battery cells 151, 153, and 155 based on the normalized OCV difference values of the plurality of battery cells 151, 153, and 155 acquired by the normalization unit 133.

According to one embodiment, the identification unit 134 may identify the suspected abnormal battery cell among the plurality of battery cells 151, 153, and 155 based on a deviation between the normalized OCV difference values. In this case, the deviation may be a value acquired by subtracting a smaller value from a larger value among two normalized OCV difference values.

For example, when the deviation between the maximum value and the second largest value among the normalized OCV difference values is greater than or equal to a first threshold value (e.g., 0.67), the identification unit 134 may identify the battery cell having the maximum value as a suspected abnormal battery cell. According to the graph 300, when a deviation 305 between the maximum value 301 and a second largest value 303 among the normalized OCV difference values in the thirteenth charge cycle is greater than or equal to the first threshold value, the identification unit 134 may identify a sixth battery cell having the maximum value 301 as the suspected abnormal battery cell.

As another example, when the deviation between the minimum value and the second smallest value among the normalized OCV difference values is greater than or equal to the second threshold value (e.g., 0.8), the identification unit 134 may identify the battery cell having the minimum value as the suspected abnormal battery cell. According to the graph 300, when a deviation 315 between a minimum value 311 and a second smallest value 313 among the normalized OCV difference values in a fourteenth charge cycle is greater than or equal to the second threshold value, the identification unit 134 may identify the sixth battery cell having the minimum value 311 as the suspected abnormal battery cell.

According to one embodiment, the diagnosis unit 135 may diagnose an abnormality of the suspected abnormal battery cell based on an OCV deviation value between the second OCV value corresponding to the second charge/discharge cycle of the suspected abnormal battery cell identified by the identification unit 134 and a representative value of the second OCV values corresponding to the second charge/discharge cycles of the plurality of battery cells 151, 153, and 155. Here, the representative value may be selected as an average value of the second OCV values or a median value of the second OCV values.

For example, the diagnosis unit 135 may calculate, according to the graph 300, an OCV deviation value between the second OCV value of the sixth battery cell identified as the suspected abnormal battery cell and the representative value of the second OCV values of the first to eighth battery cells through the graph 210, and may diagnose the abnormality of the sixth battery cell based on the calculated OCV deviation value.

According to one embodiment, the diagnosis unit 135 may diagnose the suspected abnormal battery cell as an abnormal battery cell when the OCV deviation value of the suspected abnormal battery cell is greater than or equal to a third threshold value.

According to one embodiment, the battery diagnosis device 101 may repeat the operations of the calculation unit 132, the normalization unit 133, the identification unit 134, and the diagnosis unit 135 for the remaining battery cells for each unit time (e.g., the charge/discharge cycle), except for the abnormal battery cell diagnosed by the diagnosis unit 135 until no abnormal battery cell is diagnosed.

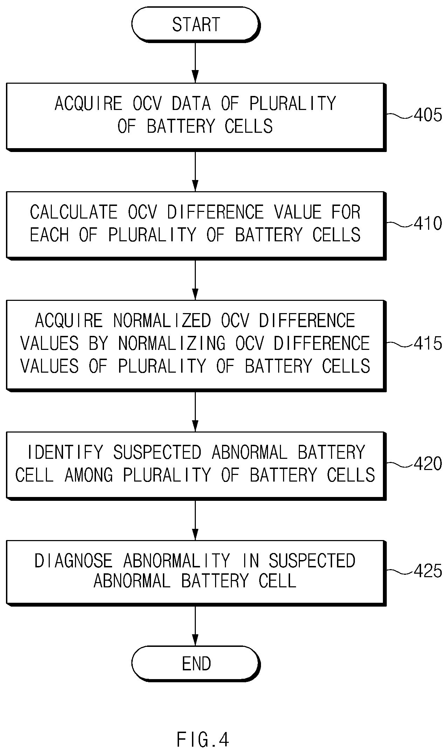

FIG. 4 is a flowchart of the operation of a battery diagnosis device according to one embodiment. FIG. 4 may be explained using the configurations of FIG. 1.

The embodiment illustrated in FIG. 4 is merely one embodiment, and the order of steps according to various embodiments of the present invention may be different from that illustrated in FIG. 4, and some steps illustrated in FIG. 4 may be omitted, the order between steps may be changed, or steps may be merged.

Referring to FIG. 4, in operation 405, the battery diagnosis device 101 may acquire OCV data of the plurality of battery cells 151, 153, and 155. For example, the battery diagnosis device 101 may measure voltage, current, and/or temperature of the plurality of battery cells 151, 153, and 155 and generate OCV data based on the measured information. In this case, the battery diagnosis device 101 may use the sensor 120 to measure the voltage, current, and/or temperature of the plurality of battery cells 151, 153, and 155. As another example, the battery diagnosis device 101 may receive the OCV data of the plurality of battery cells 151, 153, and 155 generated by the electronic device 102 from the electronic device 102 using the communication circuit 110.

In operation 410, the battery diagnosis device 101 may calculate an OCV difference value for each of the plurality of battery cells 151, 153, and 155 based on the OCV data acquired in operation 405. The OCV difference value may be a difference value between two OCV values corresponding to each of two charge/-

discharge cycles among the plurality of charge/discharge cycles included in a time period of the OCV data. Here, the charge/discharge cycle may include a charge cycle and a discharge cycle.

According to one embodiment, the OCV difference value may be a difference value between a first OCV value corresponding to a first charge/discharge cycle among the plurality of charge/discharge cycles and a second OCV value corresponding to a second charge/-discharge cycle among the plurality of charge/discharge cycles. In this case, the second charge/discharge cycle may be a cycle adjacent to the first charge/discharge cycle after the first charge/discharge cycle. In addition, the OCV difference value may be a value acquired by subtracting the first OCV value from the second OCV value.

According to one embodiment, the battery diagnosis device 101 may calculate the OCV difference value based on one type of the charge cycle or discharge cycle included in the charge/discharge cycle.

As an example, the battery diagnosis device 101 may calculate the OCV difference value between the first OCV value corresponding to the first charge cycle and the second OCV value corresponding to the second charge cycle after the first charge cycle among the plurality of charge cycles included in the time section of the OCV data. In this case, the OCV value corresponding to each charge cycle may be selected as an OCV value at a time point after a designated time (e.g., 2 hours) has passed after each charge cycle ends. For example, the battery diagnosis device 101 may calculate a difference value between the first OCV value at a time point after a designated time has passed after the end of the first charge cycle and the second OCV value at a time point after a designated time has passed after the end of the second charge cycle as the OCV difference value.

As another example, the battery diagnosis device 101 may calculate the OCV difference value between the first OCV value corresponding to the first discharge cycle and the second OCV value corresponding to the second discharge cycle after the first discharge cycle among the plurality of discharge cycles included in the time section of the OCV data. In this case, the OCV value corresponding to each discharge cycle may be selected as an OCV value at a time point after a designated time (e.g., 2 hours) has passed after each discharge cycle ends. For example, the battery diagnosis device 101 may calculate a difference value between the first OCV value at a time point after a designated time has passed after the end of the first discharge cycle and the second OCV value at a time point after a designated time has passed after the end of the second discharge cycle as the OCV difference value.

In operation 415, the battery diagnosis device 101 may acquire normalized OCV difference values by normalizing the OCV difference values of the plurality of battery cells 151, 153, and 155 calculated by the calculation unit 132. For example, the battery diagnosis device 101 may acquire the normalized OCV difference values by normalizing the OCV difference values based on Equation 1 below.

In operation 420, the battery diagnosis device 101 may identify a suspected abnormal battery cell among the plurality of battery cells 151, 153, and 155 based on the normalized OCV difference values of the plurality of battery cells 151, 153, and 155 acquired in operation 415.

According to one embodiment, the battery diagnosis device 101 may identify the suspected abnormal battery cell among the plurality of battery cells 151, 153, and 155 based on the deviation between the normalized OCV difference values. In this case, the deviation may be a value obtained by subtracting a smaller value from a larger value among two normalized OCV difference values.

For example, when the deviation between the maximum value and the second largest value among the normalized OCV difference values is greater than or equal to a first threshold value (e.g., 0.67), the battery diagnosis device 101 may identify the battery cell having the maximum value as the suspected abnormal battery cell.

As another example, when the deviation between the minimum value and the second smallest value among the normalized OCV difference values is greater than or equal to the second threshold value (e.g., 0.8), the battery diagnosis device 101 may identify the battery cell having the minimum value as the suspected abnormal battery cell.

In operation 425, the battery diagnosis device 101 may diagnose an abnormality of the suspected abnormal battery cell identified in operation 420. According to one embodiment, the battery diagnosis device 101 may diagnose the abnormality of the suspected abnormal battery cell based on an OCV deviation value between the second OCV value corresponding to the second charge/discharge cycle of the suspected abnormal battery cell and a representative value of the second OCV values corresponding to the second charge/discharge cycles of the plurality of battery cells 151, 153, and 155. Here, the representative value may be selected as an average value of the second OCV values or a median value of the second OCV values.

According to one embodiment, the battery diagnosis device 101 may diagnose the suspected abnormal battery cell as the abnormal battery cell when the OCV deviation value of the suspected abnormal battery cell is greater than or equal to a third threshold value.

According to one embodiment, the battery diagnosis device 101 may repeat the operations 410 to 425 for the remaining battery cells for each unit time (e.g., charge/discharge cycle), except for the abnormal battery cell diagnosed in operations 425 until no abnormal battery cell is diagnosed.

The terms "include," "configure," or "have" described above, unless specifically stated to the contrary, mean that the corresponding component may be included, and therefore should be interpreted as further including other components rather than excluding other components. All terms including technical or scientific terms have the same meaning as commonly understood by a person skilled in the art to which the embodiments disclosed in this document belong, unless otherwise defined. Terms commonly used, such as terms defined in the dictionary, should be interpreted as being consistent with the contextual meaning of the relevant technology, and should not be interpreted in an idealized or overly formal sense unless clearly defined in this document.

## Claims

1. A battery diagnosis device comprising:

   an acquisition unit that acquires open circuit voltage (OCV) data of a plurality of battery cells;
   a calculation unit that calculates, for each of the plurality of battery cells, an OCV difference value between a first OCV value corresponding to a first charge/discharge cycle and a second OCV value corresponding to a second charge/discharge cycle after the first charge/discharge cycle based on the OCV data;
   a normalization unit that acquires normalized OCV difference values by normalizing OCV difference values of the plurality of battery cells;
   an identification unit that identifies a suspected abnormal battery cell among the plurality of battery cells based on the normalized OCV difference values; and
   a diagnosis unit that diagnoses an abnormality of the suspected abnormal battery cell based on an OCV deviation value between a second OCV value of the identified suspected abnormal battery cell and a representative value of second OCV values of the plurality of battery cells.

2. The battery diagnosis device of claim 1, wherein the normalization unit normalizes the OCV difference values of the plurality of battery cells based on Equation 1 below to acquire the normalized OCV difference values,

   [Equation 1]

   $$\frac{dOCV_i - dOCV_{min}}{dOCV_{max} - dOCV_{min}}$$

   (in Equation 1, $dOCV_i$ is the OCV difference value of an i-th battery cell among the plurality of battery cells, $dOCV_{min}$ is a minimum value of the OCV difference values of the plurality of battery cells, and $dOCV_{max}$

is a maximum value of the OCV difference values of the plurality of battery cells).

3. The battery diagnosis device of claim 1, wherein the identification unit identifies the suspected abnormal battery cell among the plurality of battery cells based on a deviation between the normalized OCV difference values.

4. The battery diagnosis device of claim 3, wherein, when a deviation between a maximum value and a second largest value among the normalized OCV difference values is greater than or equal to a first threshold value, the identification unit identifies a battery cell having the maximum value as the suspected abnormal battery cell.

5. The battery diagnosis device of claim 3, wherein, when a deviation between a minimum value and a second smallest value among the normalized OCV difference values is greater than or equal to a second threshold value, the identification unit may identify a battery cell having the minimum value as the suspected abnormal battery cell.

6. The battery diagnosis device of claim 1, wherein, when the OCV deviation value of the suspected abnormal battery cell is greater than or equal to a third threshold value, the diagnosis unit diagnoses the suspected abnormal battery cell as an abnormal battery cell.

7. The battery diagnosis device of claim 1, wherein the first OCV value is an OCV value corresponding to a charge cycle included in the first charge/discharge cycle, and the second OCV value is an OCV value corresponding to a charge cycle included in the second charge/discharge cycle.

8. The battery diagnosis device of claim 1, wherein the first OCV value is an OCV value corresponding to a discharge cycle included in the first charge/discharge cycle, and the second OCV value is an OCV value corresponding to a discharge cycle included in the second charge/discharge cycle.

9. An operating method of a battery diagnosis device, comprising:

   an operation of acquiring open circuit voltage OCV data of a plurality of battery cells;
   an operation of calculating, for each of the plurality of battery cells, an OCV difference value between a first OCV value corresponding to a first charge/discharge cycle and a second OCV value corresponding to a second charge/discharge cycle after the first charge/discharge cycle based on the OCV data;

an operation of acquiring normalized OCV difference values by normalizing the OCV difference values of the plurality of battery cells;

an operation of identifying a suspected abnormal battery cell among the plurality of battery cells based on the normalized OCV difference values; and

an operation of diagnosing an abnormality of the suspected abnormal battery cell based on an OCV deviation value between a second OCV value of the identified suspected abnormal battery cell and a representative value of second OCV values of the plurality of battery cells.

10. The operating method of claim 9, wherein the operation of acquiring the normalized OCV difference values may include an operation of acquiring the normalized OCV difference values by normalizing the OCV difference values of the plurality of battery cells based on Equation 1 above,

[Equation 1]

$$\frac{dOCV_i - dOCV_{min}}{dOCV_{max} - dOCV_{min}}$$

(in Equation 1, $dOCV_i$ is the OCV difference value of an i-th battery cell among the plurality of battery cells, $dOCV_{min}$ is a minimum value of the OCV difference values of the plurality of battery cells, and $dOCV_{max}$ is a maximum value of the OCV difference values of the plurality of battery cells).

11. The operating method of claim 9, wherein the operation of identifying the suspected abnormal battery cell includes an operation of identifying the suspected abnormal battery cell among the plurality of battery cells based on a deviation between the normalized OCV difference values.

12. The operating method of claim 11, wherein the operation of identifying the suspected abnormal battery cell includes an operation of identifying, when a deviation between the maximum value and the second largest value among the normalized OCV difference values is greater than or equal to a first threshold value, a battery cell having the maximum value as the suspected abnormal battery cell.

13. The operating method of claim 11, wherein the operation of identifying the suspected abnormal battery cell includes an operation of identifying, when a deviation between the minimum value and the second smallest value among the normalized OCV difference values is greater than or equal to a second threshold value, a battery cell having the minimum value as the suspected abnormal battery cell.

14. The operating method of claim 9, wherein the operation of diagnosing the abnormality of the suspected abnormal battery cell includes an operation of diagnosing the suspected abnormal battery cell as an abnormal battery cell when the OCV deviation value of the suspected abnormal battery cell is greater than or equal to a third threshold value.

15. The operating method of claim 9, wherein the first OCV value is an OCV value corresponding to a charge cycle included in the first charge/discharge cycle, and the second OCV value is an OCV value corresponding to a charge cycle included in the second charge/discharge cycle.

FIG.1

210

● FIRST BATTERY CELL ─○─ SECOND BATTERY CELL ─□─ THIRD BATTERY CELL ─◇─ FOURTH BATTERY CELL
─△─ FIFTH BATTERY CELL ─▽─ SIXTH BATTERY CELL ─⬠─ SEVENTH BATTERY CELL ─☆─ EIGHTH BATTERY CELL

OCV DIFFERENCE VALUE(V)

CHARGE CYCLE

FIG.2A

EP 4 764 534 A1

220

FIRST BATTERY CELL    SECOND BATTERY CELL    THIRD BATTERY CELL    FOURTH BATTERY CELL

FIFTH BATTERY CELL    SIXTH BATTERY CELL    SEVENTH BATTERY CELL    EIGHTH BATTERY CELL

OCV DIFFERENCE VALUE(V)

DISCHARGE CYCLE

FIG.2B

● FIRST BATTERY CELL ○ SECOND BATTERY CELL □ THIRD BATTERY CELL ◇ FOURTH BATTERY CELL
△ FIFTH BATTERY CELL ▽ SIXTH BATTERY CELL ⬠ SEVENTH BATTERY CELL ☆ EIGHTH BATTERY CELL

FIG.3

EP 4 764 534 A1

START

ACQUIRE OCV DATA OF PLURALITY
OF BATTERY CELLS —405

CALCULATE OCV DIFFERENCE VALUE FOR
EACH OF PLURALITY OF BATTERY CELLS —410

ACQUIRE NORMALIZED OCV DIFFERENCE
VALUES BY NORMALIZING OCV DIFFERENCE
VALUES OF PLURALITY OF BATTERY CELLS —415

IDENTIFY SUSPECTED ABNORMAL BATTERY
CELL AMONG PLURALITY OF BATTERY CELLS —420

DIAGNOSE ABNORMALITY IN SUSPECTED
ABNORMAL BATTERY CELL —425

END

FIG.4

## INTERNATIONAL SEARCH REPORT

| International application No. |
| --- |
| **PCT/KR2025/000199** |

### A. CLASSIFICATION OF SUBJECT MATTER

**G01R 31/3835**(2019.01)i; **G01R 31/396**(2019.01)i; **G01R 19/10**(2006.01)i; **G01R 19/165**(2006.01)i; **G01R 19/30**(2006.01)i

According to International Patent Classification (IPC) or to both national classification and IPC

### B. FIELDS SEARCHED

Minimum documentation searched (classification system followed by classification symbols)

G01R 31/3835(2019.01); G01R 31/36(2006.01); G01R 31/389(2019.01); G01R 31/392(2019.01); H01M 10/42(2006.01); H01M 10/48(2006.01); H02J 7/00(2006.01); H02J 7/02(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리(battery), 개방회로전압(OCV, Open Circuit Voltage), 편차(deviation), 이상(abnormal), 진단(diagnosis)

### C. DOCUMENTS CONSIDERED TO BE RELEVANT

| Category* | Citation of document, with indication, where appropriate, of the relevant passages | Relevant to claim No. |
| --- | --- | --- |
| A | KR 10-2020-0111015 A (LG CHEM, LTD.) 28 September 2020 (2020-09-28)<br>See paragraphs [0052]-[0079], claim 1 and figures 1-2. | 1-15 |
| A | KR 10-2021-0100845 A (SK INNOVATION CO., LTD.) 18 August 2021 (2021-08-18)<br>See paragraphs [0064]-[0068], claims 1-7 and figures 2-6. | 1-15 |
| A | JP 2002-010512 A (NISSAN MOTOR CO., LTD.) 11 January 2002 (2002-01-11)<br>See claims 1-5 and figures 1-5. | 1-15 |
| A | JP 2021-083137 A (HITACHI ASTEMO LTD.) 27 May 2021 (2021-05-27)<br>See paragraphs [0059]-[0060] and figures 1-4. | 1-15 |
| A | CN 112838631 B (SHANGHAI MEIKE ENERGY STORAGE TECHNOLOGY CO., LTD.) 29 December 2023 (2023-12-29)<br>See claims 1-4 and figure 1. | 1-15 |

☐ Further documents are listed in the continuation of Box C.  ☑ See patent family annex.

| | |
| --- | --- |
| * Special categories of cited documents:<br>"A" document defining the general state of the art which is not considered to be of particular relevance<br>"D" document cited by the applicant in the international application<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
| --- | --- |
| **07 April 2025** | **07 April 2025** |

| Name and mailing address of the ISA/KR | Authorized officer |
| --- | --- |
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT
### Information on patent family members

International application No.

**PCT/KR2025/000199**

| Patent document cited in search report | | | Publication date (day/month/year) | Patent family member(s) | | | Publication date (day/month/year) |
|---|---|---|---|---|---|---|---|
| KR | 10-2020-0111015 | A | 28 September 2020 | CN | 113646652 | A | 12 November 2021 |
| | | | | CN | 113646652 | B | 15 August 2023 |
| | | | | EP | 3828569 | A1 | 02 June 2021 |
| | | | | EP | 3828569 | B1 | 07 February 2024 |
| | | | | ES | 2976735 | T3 | 07 August 2024 |
| | | | | HU | E066465 | T2 | 28 August 2024 |
| | | | | JP | 2022-503514 | A | 12 January 2022 |
| | | | | JP | 7119262 | B2 | 17 August 2022 |
| | | | | PL | 3828569 | T3 | 06 May 2024 |
| | | | | US | 11824395 | B2 | 21 November 2023 |
| | | | | US | 2021-0218262 | A1 | 15 July 2021 |
| | | | | WO | 2020-189918 | A1 | 24 September 2020 |
| KR | 10-2021-0100845 | A | 18 August 2021 | US | 11774508 | B2 | 03 October 2023 |
| | | | | US | 2021-0247457 | A1 | 12 August 2021 |
| | | | | US | 2023-0408591 | A1 | 21 December 2023 |
| JP | 2002-010512 | A | 11 January 2002 | JP | 2002-010511 | A | 11 January 2002 |
| | | | | JP | 3624800 | B2 | 02 March 2005 |
| | | | | JP | 3709766 | B2 | 26 October 2005 |
| | | | | US | 2002-0011820 | A1 | 31 January 2002 |
| | | | | US | 6417648 | B2 | 09 July 2002 |
| JP | 2021-083137 | A | 27 May 2021 | WO | 2019-176369 | A1 | 19 September 2019 |
| CN | 112838631 | B | 29 December 2023 | CN | 112838631 | A | 25 May 2021 |

Form PCT/ISA/210 (patent family annex) (July 2022)

**REFERENCES CITED IN THE DESCRIPTION**

**Patent documents cited in the description**

- KR 1020240002060